# EUROPEAN PATENT APPLICATION

(11) **EP 2 180 771 A1**
(43) Date of publication of application: **28.04.2010**
(21) Application number: 07790804.4
(22) Date of filing: 13.07.2007
(51) Int. Cl.: H05K 3/46

(54) **WIRING BOARD AND MANUFACTURING METHOD THEREOF**

(71) Applicant: Ibiden Co., Ltd., Ogaki-shi, Gifu 503-8604 (JP)
(72) Inventor: TAKAHASHI, Michimasa, Ogaki-shi Gifu 503-8503 (JP); AOYAMA, Masakazu, Ogaki-shi Gifu 503-8503 (JP)
(74) Representative: Gendron, Vincent Christian
(86) International application number: PCT/JP2007/064024
(87) International publication number: WO 2009/011024

(57) **Abstract**

A wiring board 19 is structured by connecting a first wiring board 17 and a second wiring board 16 with a pliable member 15. The first wiring board 17 is structured by laminating a first substrate 1, a non-pliable second substrate 2 having a smaller mounting area than that of the first substrate 1, and a base substrate 3 formed between the first substrate 1 and the second substrate 2, where at least a portion of the periphery is formed thinner than the central portion. Vias 44 are formed at least either in the first substrate 1 or the second substrate 2.

## Description

### Technical Field

The present invention relates to a wiring board formed by combining multiple boards each having a different mounting area, and a method of manufacturing such a wiring board.

### Background Art

Among electronic devices, some are preferred to be made compact and lightweight; cell phones especially are expected to be made thin in addition to being made compact and lightweight. Also, wiring boards to be used in cell phones are expected to be made compact, lightweight and thin.

However, if a wiring board is made thin, etc., the wiring board becomes insufficiently rigid. For example, Patent Literature 1 discloses a technique to address insufficient rigidity of a wiring board. This technique is employed in a wiring board having a reinforced portion, which is formed by making an extended portion of a flexible substrate and folding the extended portion.

In this technique, however, a part of the extended portion is folded over to a conductive pattern thereon which is eventually disconnected. Since this technique uses a flexible substrate, the cost for manufacturing a wiring board is high. A reinforced portion can be provided on the wiring board using a rigid substrate instead of a flexible substrate so as to increase the thickness of some parts of the wiring board. However, for example, when the wiring board using this technique is dropped, an impact arising therefrom is transmitted to the wiring board, and wires connecting electronic components are eventually disconnected.

In the meantime, to increase the number of mounting components, a wiring board having a flexible substrate and a multilayered built-up substrate has been developed. A flexible substrate is pliable and thin, thus the space it occupies in a wiring board may be small. In addition, a flexible substrate is often used in an electronic device whose casing is occasionally bent. Also, a multilayered built-up substrate may be highly integrated, thus the space it occupies in a wiring board may be made small.

However, when manufacturing a wiring board having a flexible substrate and a multilayered built-up substrate, in a step to form a conductive pattern on an outer layer of the built-up substrate, there are occasions when the etching resist is poorly formed. Therefore, the techniques disclosed in Patent Literature 2 include a technique to address the level difference between the flexible substrate and the built-up substrate in a process to form a conductive pattern on an outer layer of the built-up substrate.

Even if the technique disclosed in Patent Literature 2 is employed, wires connecting electronic components are eventually disconnected when an electronic device, such as a cell phone, receives an impact such as from being dropped or the like and the impact reaches the electronic components on the wiring board.
Patent Literature 1: Unexamined Japanese Patent Application KOKAI Publication No. H5-152693
Patent Literature 2: Unexamined Japanese Patent Application KOKAI Publication No. 2006-216785

### Disclosure of Invention

### Problem to be Solved by the Invention

The present invention is to solve the above subject matter; namely, to provide a wiring board and its manufacturing method where the risk of rupture in the wiring that connects electronic components mounted on a wiring board is minimized when the wiring board receives an impact such as from being dropped or the like.

### Means for Solving the Problem

To achieve the above objective, a wiring board according to the first aspect of the present invention has a first wiring board, which is structured by laminating a first substrate, a non-pliable second substrate having a smaller mounting area than that of the first substrate, and a base substrate placed between the first substrate and the second substrate, with at least a portion of the periphery made thinner than the central portion, and vias formed at least either in the first substrate or the second substrate; a second wiring board; and a pliable member to connect the first wiring board and the second wiring board.

Moreover, to achieve the above objective, a method of manufacturing a wiring board according to the second aspect of the present invention has a base-substrate forming step to form a base substrate; a connection step, while arranging a pliable member adjacent to the base substrate, to connect the pliable member to the second wiring board; an insulation layer forming step to form insulation layers on both surfaces of the base substrate, at least one of which is a non-pliable insulation layer; a via forming step to form vias in the insulation layers; and a first wiring board forming step, by cutting the insulation layers, to form a first substrate and a non-pliable second substrate that has a smaller mounting area than that of the first substrate, while forming at least a portion of the periphery to be thinner than the central portion.

### Effect of the Invention

When a wiring board according to the present invention is, e.g., dropped and is subject to an impact induced thereby, wires connecting electronic components mounted on the wiring board are not easily disconnected.

### Brief Description of Drawings

Fig. 1A is a side view illustrating a wiring board according to an embodiment of the present invention.
Fig. 1B is a plan view illustrating a wiring board according to an embodiment of the present invention.
Fig. 2 is a cross-sectional view illustrating a wiring board according to an embodiment of the present invention.
Fig. 3 is a cross-sectional view illustrating a wiring board according to an embodiment of the present invention.
Fig. 4 is a cross-sectional view illustrating a wiring board according to an embodiment of the present invention.
Fig. 5 is a cross-sectional view illustrating a wiring board according to an embodiment of the present invention.
Fig. 6 is a cross-sectional view illustrating a wiring board according to an embodiment of the present invention.
Fig. 7A illustrates a step of a method to manufacture a wiring board according to an embodiment of the present invention.
Fig. 7B illustrates a step of a method to manufacture a wiring board according to an embodiment of the present invention.
Fig. 7C illustrates a step of a method to manufacture a wiring board according to an embodiment of the present invention.
Fig. 7D illustrates a step of a method to manufacture a wiring board according to an embodiment of the present invention.
Fig. 7E illustrates a step of a method to manufacture a wiring board according to an embodiment of the present invention.
Fig. 7F illustrates a step of a method to manufacture a wiring board according to an embodiment of the present invention.
Fig. 7G illustrates a step of a method to manufacture a wiring board according to an embodiment of the present invention.
Fig. 7H illustrates a step of a method to manufacture a wiring board according to an embodiment of the present invention.
Fig. 7I illustrates a step of a method to manufacture a wiring board according to an embodiment of the present invention.
Fig. 7J illustrates a step of a method to manufacture a wiring board according to an embodiment of the present invention.
Fig. 7K illustrates a step of a method to manufacture a wiring board according to an embodiment of the present invention.
Fig. 7L illustrates a step of a method to manufacture a wiring board according to an embodiment of the present invention.
Fig. 7M illustrates a step of a method to manufacture a wiring board according to an embodiment of the present invention.
Fig. 7N illustrates a step of a method to manufacture a wiring board according to an embodiment of the present invention.
Fig. 7O illustrates a step of a method to manufacture a wiring board according to an embodiment of the present invention.
Fig. 7P illustrates a step of a method to manufacture a wiring board according to an embodiment of the present invention.
Fig. 7Q illustrates a step of a method to manufacture a wiring board according to an embodiment of the present invention.
Fig. 7R illustrates a step of a method to manufacture a wiring board according to an embodiment of the present invention.
Fig. 7S illustrates a step of a method to manufacture a wiring board according to an embodiment of the present invention.
Fig. 7T is a view illustrating wiring boards according to an embodiment of the present invention.
Fig. 8 is a cross-sectional view of a wiring board according to an embodiment of the present invention.
Fig. 9A illustrates a step of a method to manufacture a wiring board according to an embodiment of the present invention.
Fig. 9B illustrates a step of a method to manufacture a wiring board according to an embodiment of the present invention.
Fig 10 is a cross-sectional view of a wiring board according to an embodiment of the present invention.
Fig. 11 is a cross-sectional view of a wiring board according to an embodiment of the present invention.
Fig. 12 is a cross-sectional view of a wiring board according to an embodiment of the present invention.
Fig. 13A is a cross-sectional view of a wiring board according to an embodiment of the present invention.
Fig. 13B is a cross-sectional view of a wiring board according to an embodiment of the present invention.
Fig. 13C is a cross-sectional view of a wiring board according to an embodiment of the present invention.
Fig. 13D is a cross-sectional view of a wiring board according to an embodiment of the present invention.
Fig. 13E is a cross-sectional view of a wiring board according to an embodiment of the present invention.
Fig. 13F is a cross-sectional view of a wiring board according to an embodiment of the present invention.
Fig. 13G is a cross-sectional view of a wiring board according to an embodiment of the present invention.
Fig. 14A is a cross-sectional view of a wiring board according to an embodiment of the present invention.
Fig. 14B is a cross-sectional view of a wiring board according to an embodiment of the present invention.
Fig. 15A is a cross-sectional view of a wiring board according to an embodiment of the present invention.
Fig. 15B is a cross-sectional view of a wiring board according to an embodiment of the present invention.

### Explanation of Reference Numerals

- 1: first substrate
- 2: second substrate
- 3: base substrate
- 5: opening
- 7: keypad
- 8: electronic chip
- 9: solder
- 10: gold pad
- 11: interlayer groove section
- 12: adhesion prevention layer
- 13: multi-layer section
- 14: fewer-layer section
- 15: pliable member
- 16: second wiring board
- 17: first wiring board
- 19: wiring board according to the present invention
- 23: base member
- 44: via
- 51: copper foil
- 52: dummy core
- 54: copper foil
- 55: core
- 61: copper foil
- 62: prepreg
- 63: through-hole
- 71: copper foil
- 72: epoxy resin
- 81: epoxy resin
- 82: copper foil
- 83: solder-resist
- 91: gold plating
- 92: electronic component

### Best Mode for Carrying Out the Invention

### (FIRST EMBODIMENT OF A WIRING BOARD ACCORDING TO A SPECIFIC EXAMPLE OF THE PRESENT INVENTION)

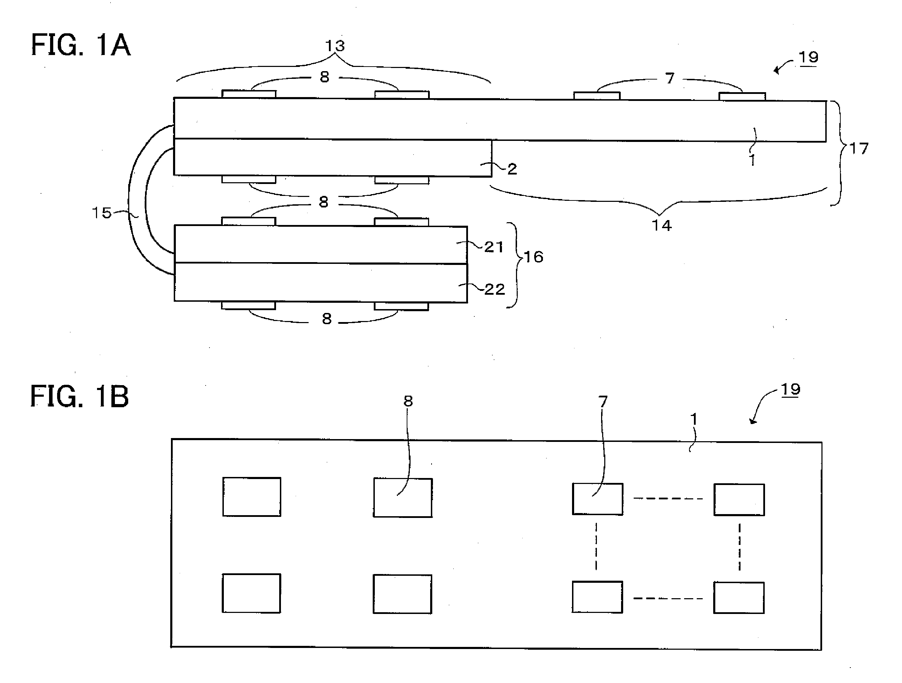

In the following, an embodiment of a wiring board according to a specific example of the present invention is described with reference to the drawings.
As shown in Fig. 1A, wiring board 19 according to a specific example of the present invention is structured by connecting first wiring board 17 and second wiring board 16 with pliable member 15. Pliable member 15 is made of polyimide resin. First wiring board 17 has a different thickness on one edge from that on the other edge. The number of layers in the section having a different thickness differs from the number of layers in the thinner section. Namely, first wiring board 17 has thick multi-layer section 13 and relatively thin fewer-layer section 14. Multi-layer section 13 is formed by laminating two layers; first substrate 1 and second substrate 2. Fewer-layer section 14 has first substrate 1 which is extended from multi-layer section 13. Second wiring board 16 is structured by laminating third substrate 21 and fourth substrate 22.

As shown in Figs. 1A and 1B, first substrate 1 and second substrate 2 have the same width and different lengths, and one end of first substrate 1 and one end of second substrate 2 are aligned. The thickness of first substrate 1 is made less than the total thickness of first substrate 1, base substrate 3 and second substrate 2, which is the thickness of the central portion. Likewise, the thickness of second substrate 2 is made less than that of the central portion, and the thickness of base substrate 3 is made less than that of the central portion. First substrate 1 and second substrate 2 are each formed with non-pliable material such as epoxy resin. Third substrate 21 and fourth substrate 22 have the same width and same length, and one end of third substrate 21 and one end of fourth substrate 22 are aligned. Third substrate 21 and fourth substrate 22 are each formed with non-pliable material such as epoxy resin.

On the surfaces (mounting surfaces) of first substrate 1, second substrate 2, third substrate 21 and fourth substrate 22, connection pads to connect electronic components are formed; on the surfaces (mounting surfaces) and the interiors of first substrate 1, second substrate 2, third substrate 21 and fourth substrate 22, wiring patterns to structure electrical circuits are formed.

On the mounting surfaces of first substrate 1 and second substrate 2, electronic components 7, 8 are arranged and connected to connection pads according to their requirements. Electronic components 7, 8 are connected with each other through connection pads and wiring patterns. Also, on the mounting surfaces of third substrate 21 and fourth substrate 22, electronic components 8 are arranged as well.

Wiring board 19 is placed, for example, in the casing of a cell phone device. In such a circumstance, electronic component 7 arranged on fewer-layer section 14 is structured, for example, with the keypad of a keyboard; and electronic components 8 arranged on multi-layer section 13, third substrate 21 and fourth substrate 22 are structured with an electronic chip, IC module, functional components and others. Also, at the step portion formed by multi-layer section 13 and fewer-layer section 14, for example, a thin-type battery is placed.

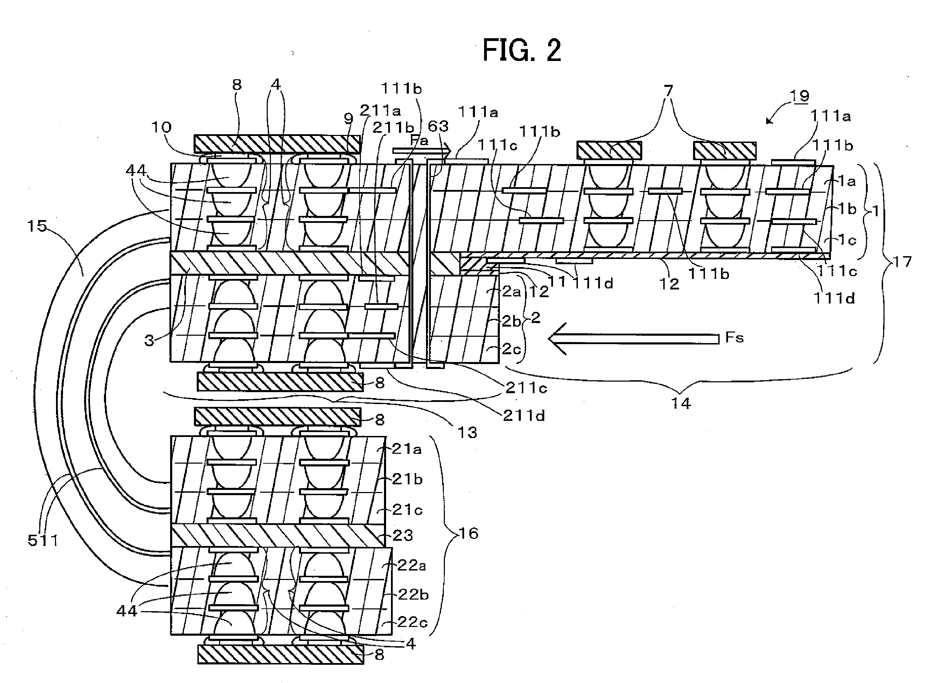

Next, a detailed structure of wiring board 19 having the above overall structure is described in reference to Fig. 2. As illustrated, first substrate 1 and second substrate 2 are laminated via base substrate 3. One end (the left end in the drawing) of base substrate 3 is made to be flush with first substrate 1 and second substrate 2. Base substrate 3 is made of highly rigid material such as glass epoxy resin. Base substrate 3 is made 50-100 µm, preferably about 100 µm. Third substrate 21 and fourth substrate 22 are laminated via base member 23. Base member 23 is made of highly rigid material such as glass epoxy resin. Base member 23 is made 50-100 µm, preferably about 100 µm.

Base substrate 3 is formed to be shorter than second substrate 2, and between first substrate 1 and second substrate 2, groove (hereinafter referred to as "interlayer groove section") 11 is formed. Interlayer groove section 11 is an aperture. The groove may be filled with elastic material or viscous material such as silicone gel or silicone oil. When wiring board 19 receives an impact from being dropped, the groove aperture or silicone gel or silicone oil that is filled in the interior of the groove cushions the impact as a shock-absorbing layer. Therefore, by being structured as such, tolerance to impact from being dropped may be improved.

First substrate 1 has a structure of laminated multiple insulation layers (1a, 1b, 1c). Each insulation layer is made of epoxy resin or the like with a thickness approximately 10 µm-60 µm. On the upper surface of insulation layer (1a), between epoxy-resin layers (1a) and (1b), between insulation layers (1b) and (1c) and on the lower surface of insulation layer (1c), wiring patterns (111a, 111b, 111c, 111d) are formed respectively. Each wiring pattern (111a, 111b, 111c, 111d) electrically connects required portions inside the circuit substrate.

Second substrate 2 also has a structure of laminated multiple insulation layers (2a, 2b, 2c) made of epoxy resin or the like with a thickness approximately 10 µm - 60 µm. On the lower surface of insulation layer (2a), between epoxy-resin layers (2a) and (2b), between insulation layers (2b) and (2c) and on the upper surface of insulation layer (2c), wiring patterns (211a, 211b, 211c, 211d) are formed respectively. Each wiring pattern (211a, 211b, 211c, 211d) electrically connects required portions inside the circuit substrate.

On the exposed portion of the lower surface of first substrate 1 and the exposed portion of the upper surface of the second substrate, adhesion prevention layers 12 as a protective insulation layer are formed. At the step portion formed when laminating first substrate 1 and second substrate 2, conductive pattern (111d) is formed. Also, to the right of conductive pattern (111d) formed at the step portion, conductive pattern (111d) is formed as well. On the surface of pliable member 15 that connects first wiring board 17 and second wiring board 16, conductive pattern 511 is formed. Conductive pattern 511 connects the wiring pattern of first substrate 1 and the wiring pattern of the second substrate 2 according to their requirements.

Third substrate 21 has a structure of laminated multiple insulation layers (21a, 21b, 21 c). Also, fourth substrate 22 has a structure of laminated multiple insulation layers (22a, 22b, 22c). Each insulation layer is made of epoxy resin or the like with a thickness approximately 10 µm - 60 µm.

Keypad 7 is arranged on the conductive pattern formed on the surface of fewer-layer section 14. Further, using solder 9, electronic chip 8 is anchored and connected to wiring patterns and built-up vias 4 through connection pads 10. For solder 9, Sn/Ag/Cu was used.

Moreover, through-hole 63 is formed, penetrating base substrate 3, further penetrating first substrate 1 and second substrate 2, and connecting wiring pattern (111a) of first substrate 1 and wiring pattern (211d) of second substrate 2. The inner surface of through-hole 63 is plated so as to electrically connect wiring patterns. The area enveloped by plated through-hole 63 may be filled with resin such as epoxy-resin.

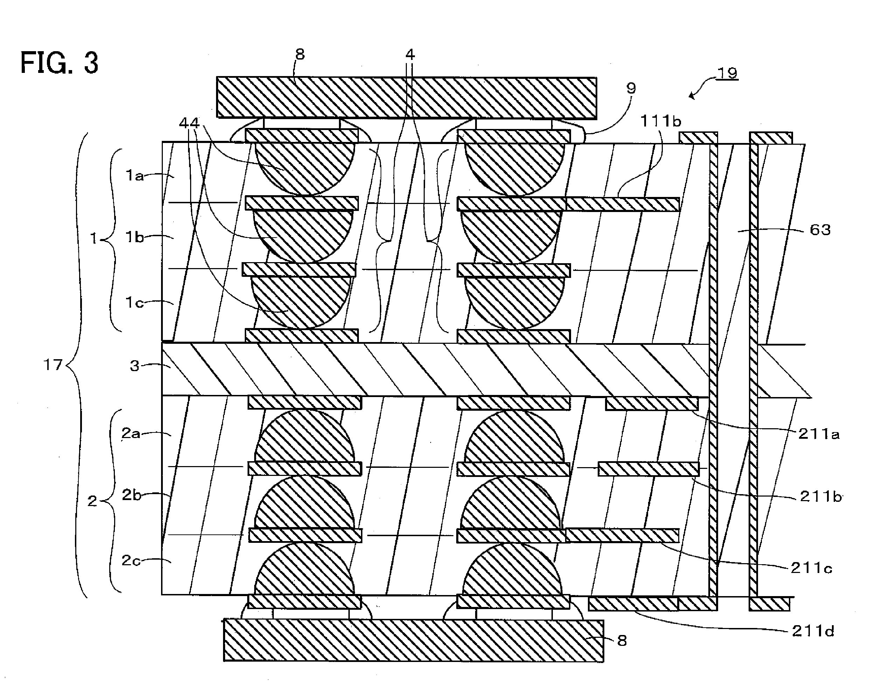

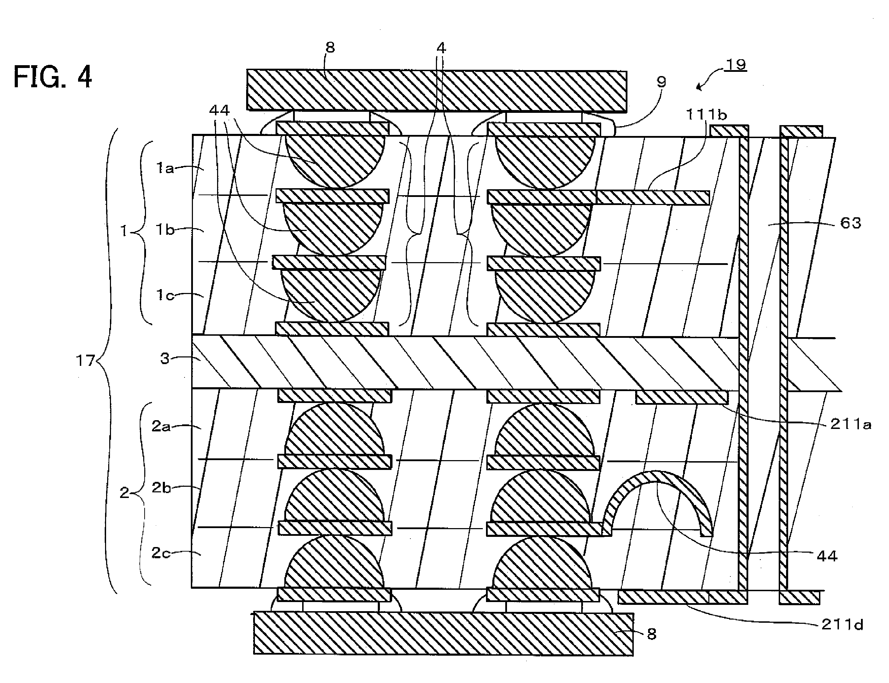

In first substrate 1, second substrate 2, third substrate 21 and fourth substrate 22, multiple built-up vias 4 are formed. Built-up vias 4 are structured by stacking vias 44 formed in each insulation layer (1a-1c, 2a-2c, 21a-21c, 22a-22c). Built-up vias 4 connect required portions of wiring patterns (111a-111d) and also connect required portions of wiring patterns (211a-211d). On the inner surface of each via 44 forming built-up vias 4, a conductive layer made of plated copper or the like is formed. As shown in Fig. 3, the interior of each via 44 is filled with conductor such as copper. As shown in Fig. 4, the interior of via 44 may also be filled with resin such as epoxy-resin.

Wiring board 19 having the above structure, for example, transmits operational signals from keypad 7 to an IC chip through built-up vias 4, wiring patterns (111a-111d) and through-hole 63, and the signals are then processed at the IC chip. By doing so, varieties of signal processing may be conducted.

Also, as described above, wiring board 19 is structured with multi-layer section 13 and fewer-layer section 14 and has a step portion. And at the lower portion of fewer-layer section 14, a large-volume component such as a cell-phone battery may be placed.

Base substrate 3 is formed with highly rigid material such as glass-epoxy resin. Multi-layer section 13, because of base substrate 3 placed there, is highly rigid compared with fewer-layer section 14. On the other hand, fewer-layer section 14 is relatively flexible compared with multi-layer section 13. Therefore, it is possible to place electronic components according to the reliability level they require when being placed.

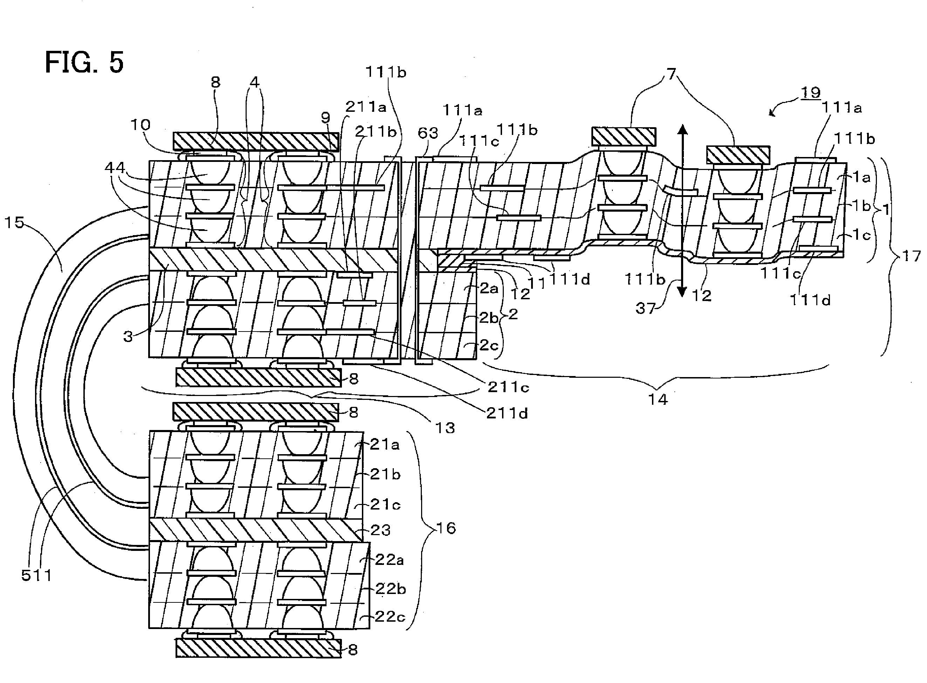

Also, for example, when the electronic device is dropped and an impact or the like is exerted on wiring board 19, due to the relative flexibility of fewer-layer section 14 compared with multi-layer section 13, as shown by arrow 37 in Fig. 5, fewer-layer section 14 vibrates. Since portions of fewer-layer section 14 vibrate, the impact from being dropped or the like is converted to vibration motion energy, and the impact is absorbed accordingly. As a result, the risk of rupture in the wiring that connects the electronic components mounted on wiring board 19 may be minimized.

Also, built-up via 4 has a stacked via structure with laminated multiple vias 44. By making such a stacked interlayer connection structure, the wiring length is shortened, and thus preferable for mounting electronic components requiring large amounts of electricity.

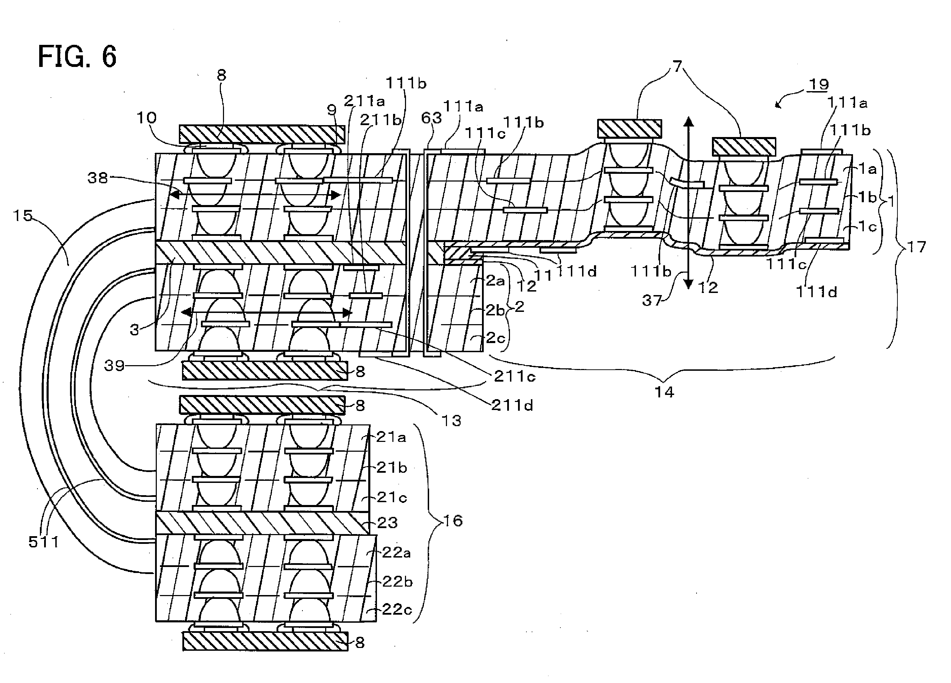

Moreover, built-up via 4 has a certain degree of mobility. Therefore, for example, when the electronic device is dropped and an impact is exerted on wiring board 19, as shown by arrows 38, 39 in Fig. 6, through the movement of built-up via 4, the impact may be absorbed at built-up via 4. As a result, the risk of rupture in the wiring that connects the electronic components mounted on wiring board 19 may be minimized.

In addition, through-hole 63, which penetrates base substrate 3, is formed, and the inner surface of through-hole 63 is plated (or filled with resin). Thus, as shown in Fig. 2, if shearing force (Fs) is exerted on the wiring board from a horizontal direction, through-hole 63 may counter the shearing force, thus preventing first substrate 1 and second substrate 2 from sliding.

Further, if solid material or the like is filled in interlayer groove section 11, when the impact from being dropped or the like is exerted on the wiring board, interlayer groove section 11 cushions the impact as a shock-absorbing layer. Accordingly, when interlayer groove section 11 is formed, by improving tolerance to impact from being dropped, the risk of rupture in the wiring that connects the electronic components mounted on the wiring board may be minimized.

Furthermore, in addition to first wiring board 17, second wiring board 16 is formed, thus additional multiple electronic components may be mounted on second wiring board 16. Accordingly, an increase in the number of mounted electronic components is achieved.

Also, in certain circumstances, two wiring boards of the present invention may be combined and sold in such a way that each fewer-layer section 14 is closely placed. Here, if a wiring pattern is formed at the step portion created when first substrate 1 and second substrate 2 are laminated, in a circumstance when a user or the like uses the combined wiring boards of the present invention separately, warping of the wiring boards may be prevented. Namely, multi-layer section 13, because of base substrate 3 placed there, is rigid compared with fewer-layer section 14. Thus, when a user or the like uses the combined wiring boards of the present invention separately, warping does not occur at multi-layer section 13. On the other hand, fewer-layer section 14 is flexible compared with multi-layer section 13. Thus, when a user or the like uses the combined wiring boards of the present invention separately, warping could possibly occur at fewer-layer section 14, especially at the step portion of fewer-layer section 14 created when first substrate 1 and second substrate 2 are laminated. However, if a wiring pattern is formed at the step portion, in a circumstance when a user or the like uses the combined wiring boards of the present invention separately, warping may be prevented.

### (METHOD OF MANUFACTURING A WIRING BOARD ACCORDING TO A SPECIFIC EXAMPLE OF THE PRESENT INVENTION)

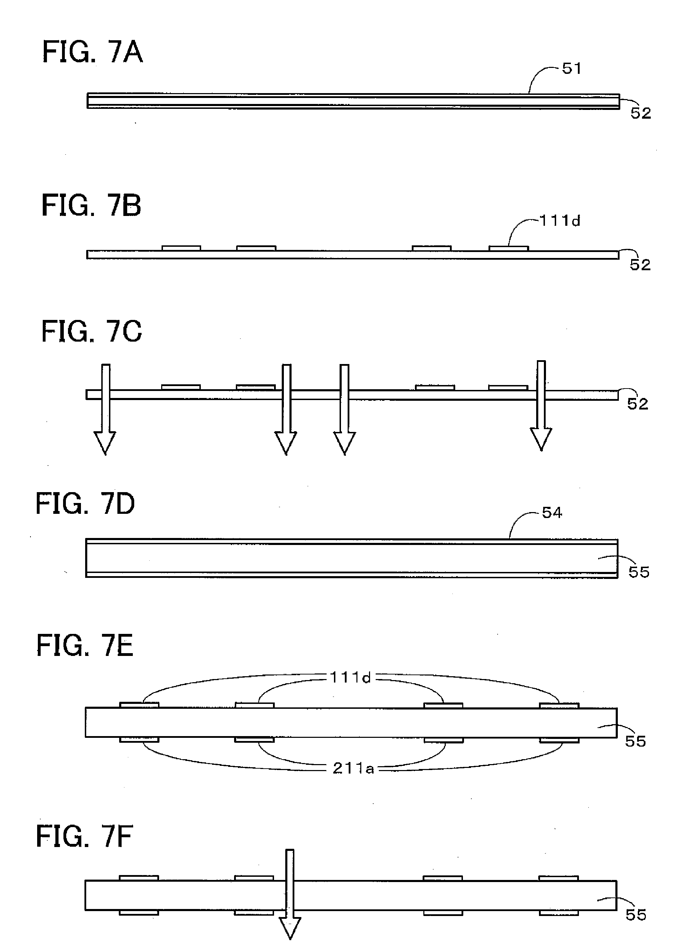

In the following, a method of manufacturing wiring board 19 according to the present invention is described.
First, as shown in Fig. 7A, dummy core 52, which will form adhesion prevention layer 12, is prepared. Dummy core 52 is formed, for example, with a C-stage epoxy-resin. On dummy core 52, copper foil 51 is deposited.

Next, as shown in Fig. 7B, by patterning copper foil 51, conductive pattern (111d) is formed at a predetermined position.

Next, as shown by arrows in Fig. 7C, dummy core 52 is cut by a laser or the like to adjust its length to a length preferred for use in wiring board 19.

Meanwhile, as shown in Fig. 7D, core 55, which will function as base substrate 3, is prepared. Core 55 is made, for example, of highly rigid material such as glass-epoxy resin. On both surfaces of core 55, copper foil 54 is deposited.

Next, as shown in Fig. 7E, by patterning copper foil 54, conductive patterns (111d, 211a) are formed to structure wiring patterns.

Next, as shown by an arrow in Fig. 7F, in core 55 using a laser or the like, a hole to insert dummy core 52 is formed.

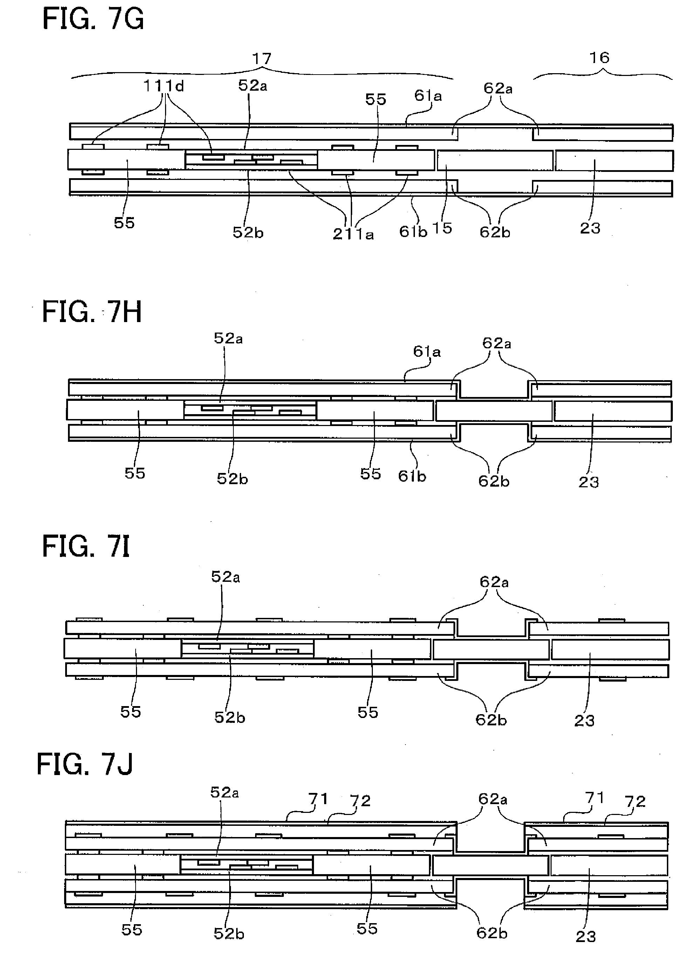

Next, as shown in Fig. 7G, cut-out dummy cores (52a, 52b) are arranged in such a way that conductive pattern (111d) and conductive pattern (211 a) are laminated facing inward. Then, laminated dummy cores (52a, 52b) and cut core 55 are horizontally connected. Further, core 55 and base member 23 are connected via pliable member 15. Pliable member 15 is arranged so as to connect first wiring board 17 and second wiring board 16. Base member 23 is placed adjacent to and on the right of core 55 as shown in the drawing, but it is also placed adjacent to and on the left of core 55 in the drawing. Next, on the top and bottom of dummy cores (52a, 52b), core 55 and base member 23, prepreg (62a, 62b) are laminated. For prepreg (62a, 62b), low-flow prepreg impregnated with low-flow epoxy-resin is preferred. Then, on the surfaces of prepreg (62a, 62b), copper foils (61a, 61b) are deposited.

Next, as shown in Fig. 7H, pressure is applied on the laminate shown in Fig. 7G. Pressure is applied, for example, by hydraulic power using hydraulic pressing equipment under conditions calling for temperature of 200°C, pressure of 40 kgf and pressing time of three (3) hours. By doing so, resin is squeezed out from the prepreg, and the prepreg and core material will be integrated accordingly. At this time, since dummy core 52 is made of a C-stage epoxy-resin, the materials in dummy core 52 are not integrated with each other. For applying pressure, vacuum pressing may be employed instead of hydraulic pressing. By conducting vacuum pressing, bubbles may be kept from mixing into the resin which structures the insulation layers. Vacuum pressing is conducted, for example, for an hour. Peak heating temperature is set, for example, at 175°C and vacuum-pressing pressure is set, for example, at 3.90 x 10⁶ [Pa].

Next, as shown in Fig. 7I, by removing the unnecessary portions of copper foil 61 from the laminate shown in Fig. 7H, wiring patterns are formed.

Next, as shown in Fig. 7J, epoxy resin 72 is further laminated to form inner layers. On both surfaces of epoxy resin 72, copper foil 71 is deposited. Then, pressure is applied. Pressure may be applied, for example, by hydraulic power using hydraulic pressing equipment, or by vacuum pressing.

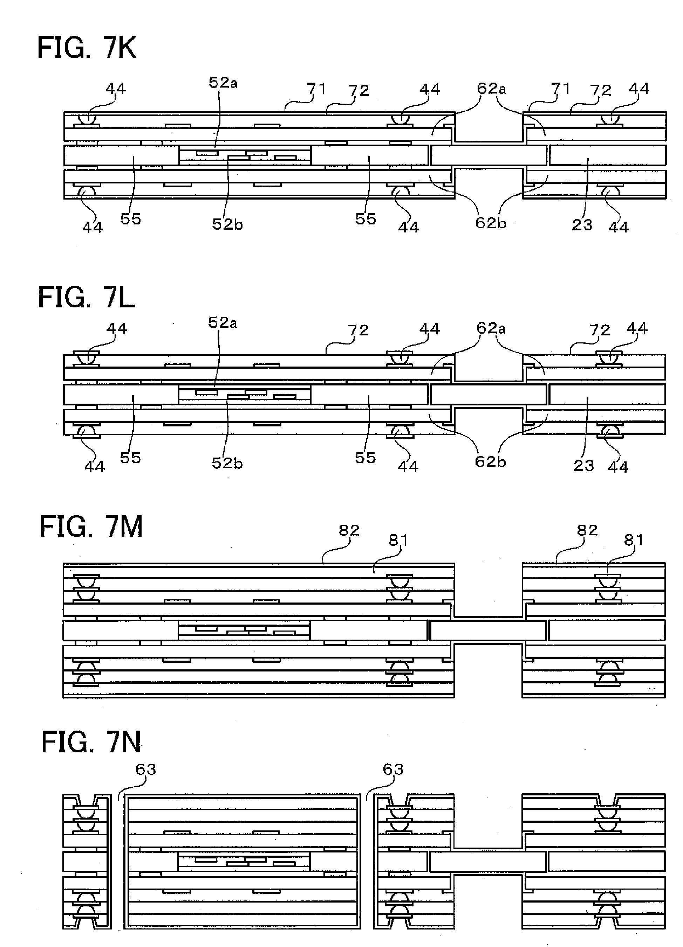

Then, as shown in Fig. 7K, vias 44 are formed. Namely, in epoxy resin 72 made of insulation resin, openings for via-holes are formed. Those openings may be formed by beaming a laser. Then, to remove resin residue remaining on the side and bottom surfaces of the openings formed by beaming a laser, a desmear treatment is performed. The desmear treatment is performed by an oxygen plasma discharge treatment, a corona discharge treatment, an ultra-violet laser treatment or an exima laser treatment. In the openings formed by beaming a laser, conductive material is filled to form filled via holes. As for the conductive material, conductive paste or metal plating formed by an electrolytic plating process is preferred. For example, vias 44 are filled with conductor such as copper plating. To reduce the manufacturing cost and improve productivity by simplifying the filled-via forming step, filling with a conductive paste is preferred. For example, a conductive paste (such as thermo-set resin containing conductive particles) may be printed by screen-printing, filled in vias 44 and cured. By filling the interiors of vias 44 with the same conductive paste material, connection reliability when thermo-stress is exerted on vias 44 may be improved. On the other hand, regarding connection reliability, metal plating formed by an electrolytic plating process is preferred. Especially, electrolytic copper plating is preferred.

Next, as shown in Fig. 7L, by removing the unnecessary portions of copper foil 71, inner-layer patterns are formed.

Next, as shown in Fig. 7M, after inner layers and vias are further formed, epoxy-resin 81 is laminated to form outer layers. On both surfaces of epoxy-resin 81, copper foil 82 is deposited. Here, a copper foil sheet containing resin (Resin Cupper Film: RCF) may be placed and pressed.

Next, as shown in Fig. 7N, vias are formed in the RCF. Further, in the laminate shown in Fig. 7M, holes are opened by a drill. The holes penetrate the base substrate and insulation layers formed on both sides of the base substrate. By doing so, through-holes 63 are formed. Then, using copper plating or the like, the interiors of the vias and through-holes 63 are filled with conductor. Also, according to requirements, by patterning the surface of the copper foil, conductive patterns are formed.

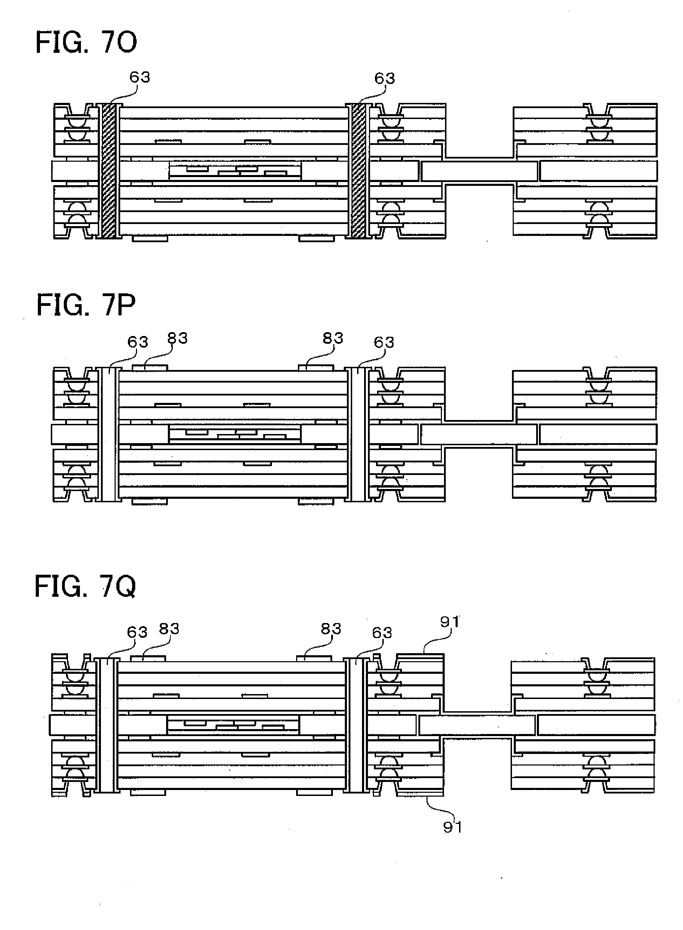

Next, as shown in Fig. 7O, the interiors of through-holes 63 are filled with epoxy resin. Then, by removing unnecessary portions of copper foils 82, outer-layer patterns are formed.

Next, as shown in Fig. 7P, solder resist 83 is formed. Here, the solder resist indicates heat-resistant coating material, which is used when applying solder to cover the portions to keep the solder from adhering. For solder-resist varieties, photo-setting-type solder resist and thermo-setting-type solder resist may be used. For a coating method, a screen-printing method or curtain-coating method may be used.

Next, as shown in Fig. 7Q, to protect outer-layer patterns, gold plating 91 is performed by chemical plating. Other than chemical plating, methods such as fusion plating and electrical plating may be used. Moreover, other than gold plating, alloy plating may be used.

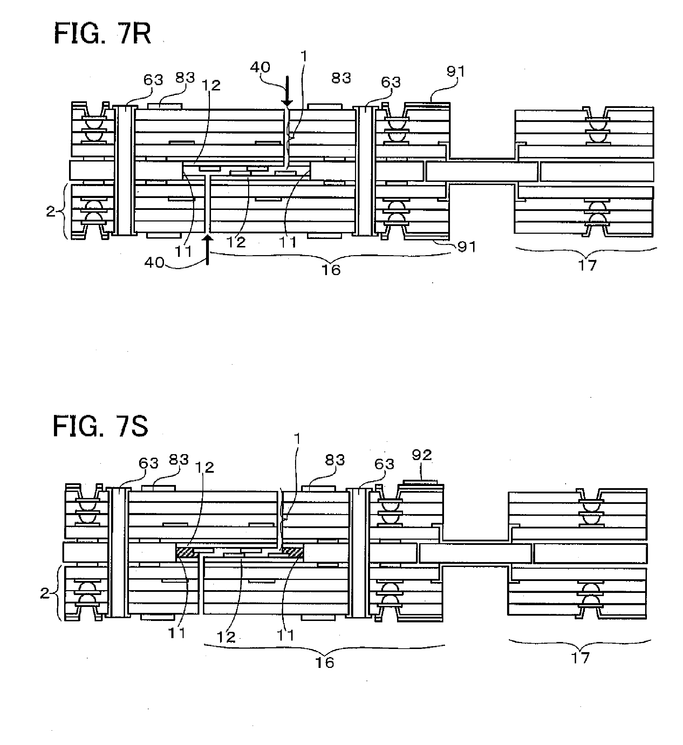

Next, as shown by arrows 40 in Fig. 7R, laser beams from laser processing equipment, for example CO₂ laser, are beamed using conductive patterns (111d) as a stopper when cutting insulation layers and the copper foil sheet containing resin (RCF). Here, the thickness of conductive patterns (111 d) is preferred to be made approximately 5-10 µm: If too thin, laser beams penetrate the pattern; and if too thick, conductive circuit patterns with a fine line width are difficult to form.
Meanwhile, by laser cutting as shown in Fig. 7R, interlayer groove sections 11 are also formed. Namely, by laser cutting, using adhesion prevention layer 12 formed in first substrate 1 and adhesion prevention layer 12 formed in second substrate 2 as side-walls of the groove, and one surface of base substrate 3 as the bottom surface of the groove, interlayer groove sections 11 are formed.

Lastly, as shown in Fig. 7S, electronic components 92 are mounted. Electronic components 92 are electronic chip 8 and keypad 7. Further, interlayer groove sections 11 may be filled with elastic material or viscous material.

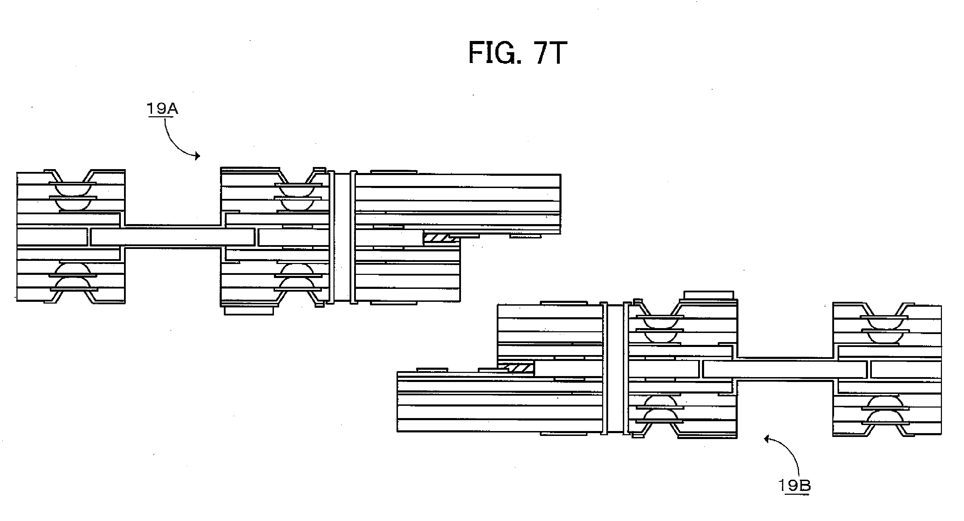

Further, as shown in Fig. 7T, wiring board (19A) and wiring board (19B) are used separately. In such a circumstance, since adhesion prevention layers 12 are formed, wiring board (19A) and wiring board (19B) may be separated by a simple process to be used separately. Regarding a wiring board according to the present invention, when an electronic device such as a cell phone receives an impact from being dropped or the like, ruptured connections among electronic components or the like mounted in the wiring board may be prevented. Also, when being shipped to a user, the wiring board can be handled compactly, and when being used by the user, the combined wiring boards can be separated easily.

### (SECOND EMBODIMENT OF A WIRING BOARD ACCORDING TO A SPECIFIC EXAMPLE OF THE PRESENT INVENTION)

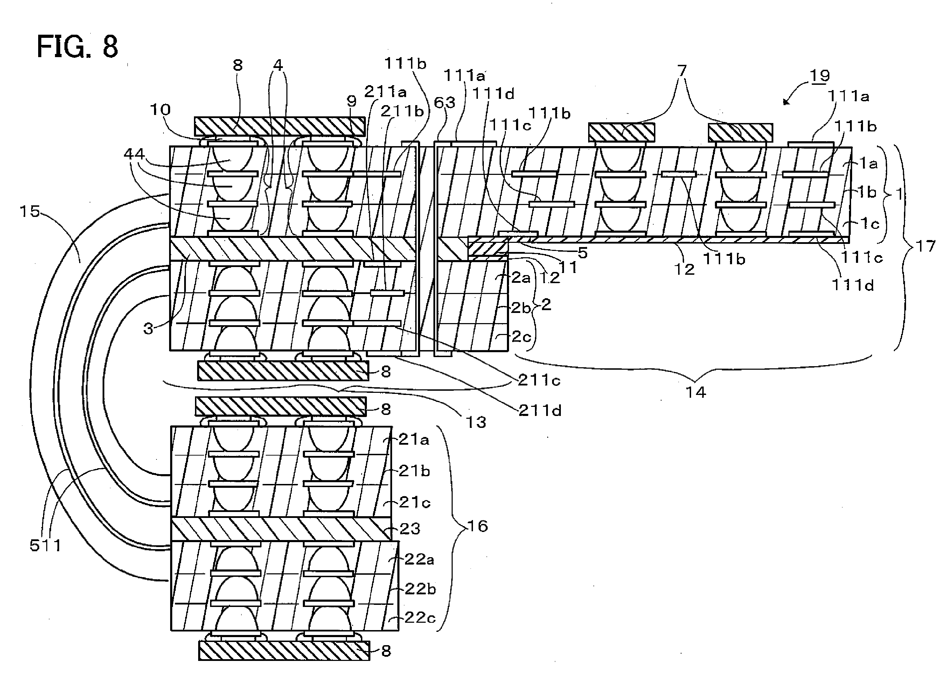

As shown in Fig. 8, according to the Second Embodiment, at the portion where adhesion prevention layer 12 is made flush with the edge of second substrate 2, opening 5 is formed. The rest of the structure is the same as in the First Embodiment. Under opening 5, part of wiring pattern (111d) is positioned. Inside the groove, which is structured with opening 5 and wiring pattern (111d) placed underneath, is an aperture. The groove may be filled with elastic material or viscous material such as silicone gel or silicone oil. When wiring board 19 receives an impact from being dropped, the aperture inside the groove or silicone gel or silicone oil filled in the groove cushions the impact as a shock-absorbing layer. Therefore, by making such a structure, tolerance to impact from being dropped may be improved.

Also, if solid material or the like is filled in opening 5, the filled solid material or the like may play a role in decreasing warping at the juncture of multi-layer section 13 and fewer-layer section 14 where the number of layers is reduced. Accordingly, at the juncture of multi-layer section 13 and fewer-layer section 14, cracks may be prevented. Furthermore, if opening 5 is filled, for example, with solid material such as resin, the filled solid material plays a role in protecting conductive pattern (111d) mounted on first substrate 1. Therefore, tolerance to corrosion on conductive pattern (111d) may be improved.

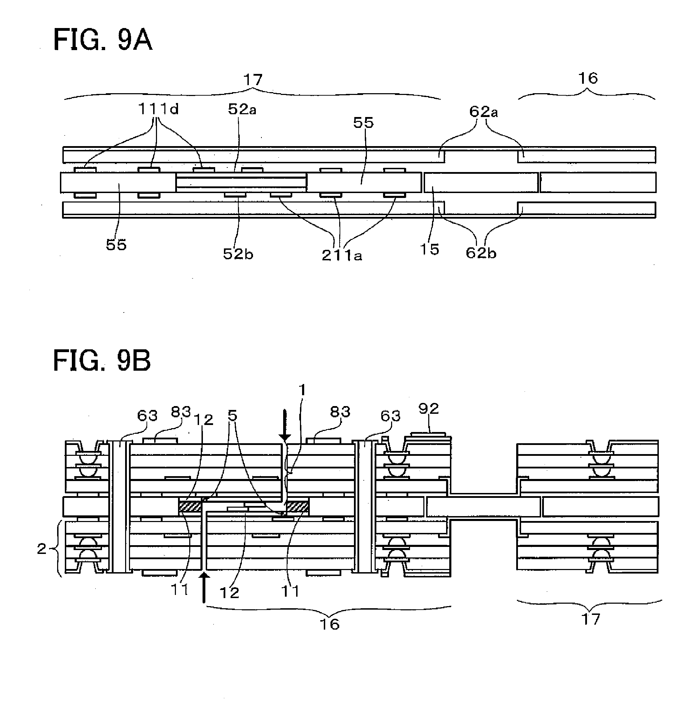

A method of manufacturing a wiring board according to the Second Embodiment is the same as the method of manufacturing a wiring board according to the First Embodiment in reference to Figs. 7A-7F, Figs. 7H-7R and 7T. Instead of Fig. 7G, as shown in Fig. 9A, cut-out dummy cores (52a, 52b) are placed in a way so that conductive pattern (111d) and conductive pattern (211 a) are laminated facing outward. Moreover, instead of Fig. 7S, as shown in Fig. 9B, opening 5 is filled with viscous material such as silicone oil.

### (THIRD EMBODIMENT OF A WIRING BOARD ACCORDING TO A SPECIFIC EXAMPLE OF THE PRESENT INVENTION)

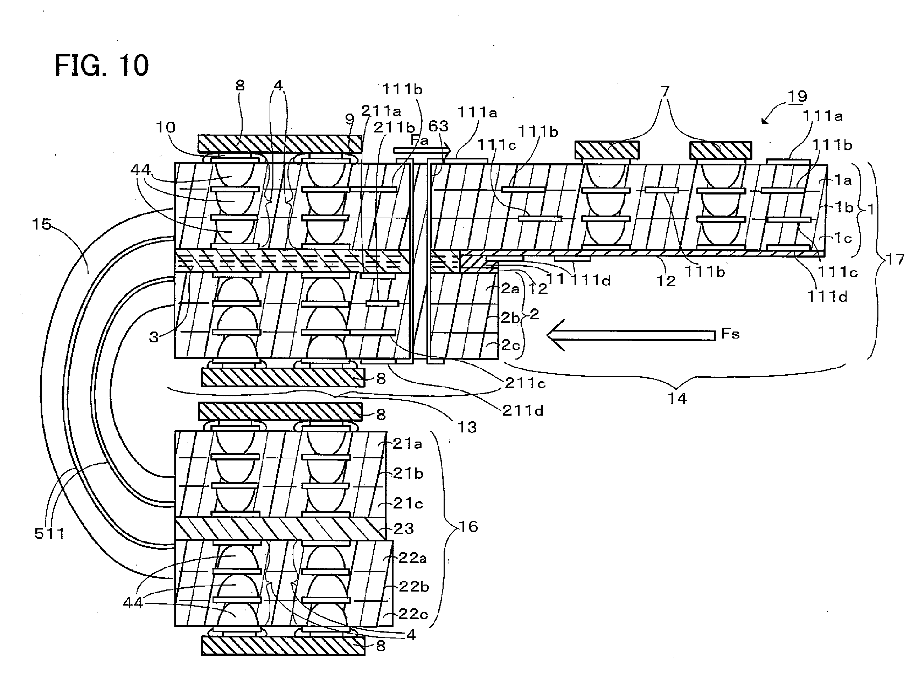

According to the First Embodiment, base substrate 3 was made of glass-epoxy resin. However, as shown in Fig. 10, according to the Third Embodiment, base substrate 3 is formed with base material of resin-impregnated inorganic fabric and first substrate 1 is formed with pliable resin. By being formed as such, since base substrate 3 contains base material of resin-impregnated inorganic fabric, tolerance to warping may be improved.

The base material of resin-impregnated inorganic fabric is made by curing a prepreg. Prepreg is made by impregnating glass-cloth inorganic fabric with epoxy-resin, then preliminarily thermosetting the resin to advance the level of curing. The resin used to make prepreg is preferred to have low-flow characteristics, but one having regular-flow characteristics may be used as well. Also, the prepreg may be prepared by reducing the content of epoxy-resin impregnated in the glass-cloth inorganic fabric.

As for the inorganic fabric, it is not limited to glass cloth, but may include, for example, alumina fabric, carbon fabric (carbon fiber), silicon carbide fabric or silicon nitride fabric.

In the method of manufacturing a wiring board according to the Third Embodiment, referring to Fig. 7D, as the material to form core 55, base material of resin-impregnated inorganic fabric is used. Also, as for the resin to form first substrate 1 that will be laminated in reference to Figs. 7G, 7J, and 7M, pliable resin is used. The rest is the same as the method of manufacturing a wiring board according to the First Embodiment.

### (FOURTH EMBODIMENT OF A WIRING BOARD ACCORDING TO A SPECIFIC EXAMPLE OF THE PRESENT INVENTION)

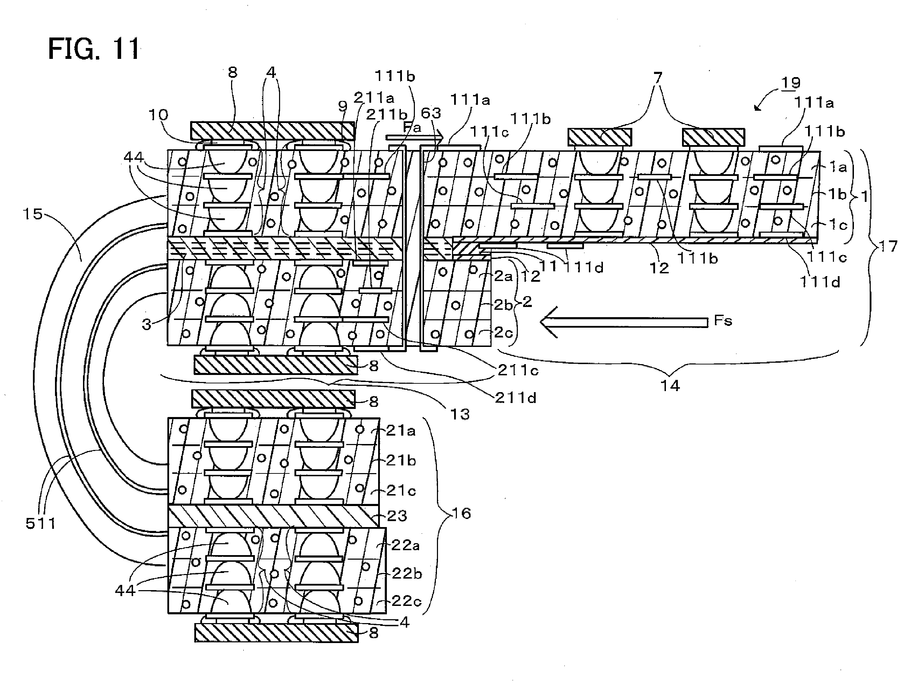

In the above-described First Embodiment, base substrate 3 was formed with glass-epoxy resin. First substrate 1 and second substrate 2 were formed with epoxy resin. However, the combination of material for base substrate 3 and material for first substrate 1 and second substrate 2 is not limited to such. As shown in Fig. 11, according to the Fourth Embodiment, base substrate 3 is formed with base material of resin-impregnated inorganic fabric; and first substrate 1 and second substrate 2 are formed with resin containing inorganic filler. By structuring so, since base substrate 3 includes base material containing resin-impregnated inorganic fabric, tolerance to warping may be improved. Accordingly, when an electronic device such as a cell phone receives an impact from being dropped or the like, the risk of rupture in the wiring that connects electronic components mounted in the wiring board may be minimized.

Resin containing inorganic filler may be made by combining silica filler or glass filler with epoxy resin. In addition to epoxy resin, or other than epoxy resin, polyimide, polycarbonate, polybutylene-telephtarate or polyacrylate may be used.

For silica filler, fused silica (SiO₂) or crystalline silica (SiO₂) may be used. Also, as for glass filler, aluminum oxide (Al₂O₃), magnesium oxide (MgO), boron nitride (BN), or aluminum nitride (AlN) may be used. Furthermore, as for inorganic filler, it is not limited to silica filler or glass filler, but antimony trioxide, antimony pentaxide or magnesium hydroxide may be used.

In the method of manufacturing a wiring board according to the Fourth Embodiment, referring to Fig. 7D, as the material to form core 55, base material of resin-impregnated inorganic fabric is used. In addition, for the resin to be laminated in reference to Figs. 7G, 7J and 7M, resin containing inorganic filler is used. The rest is the same as the method of manufacturing a wiring board according to the First Embodiment.

### (FIFTH EMBODIMENT OF A WIRING BOARD ACCORDING TO A SPECIFIC EXAMPLE OF THE PRESENT INVENTION)

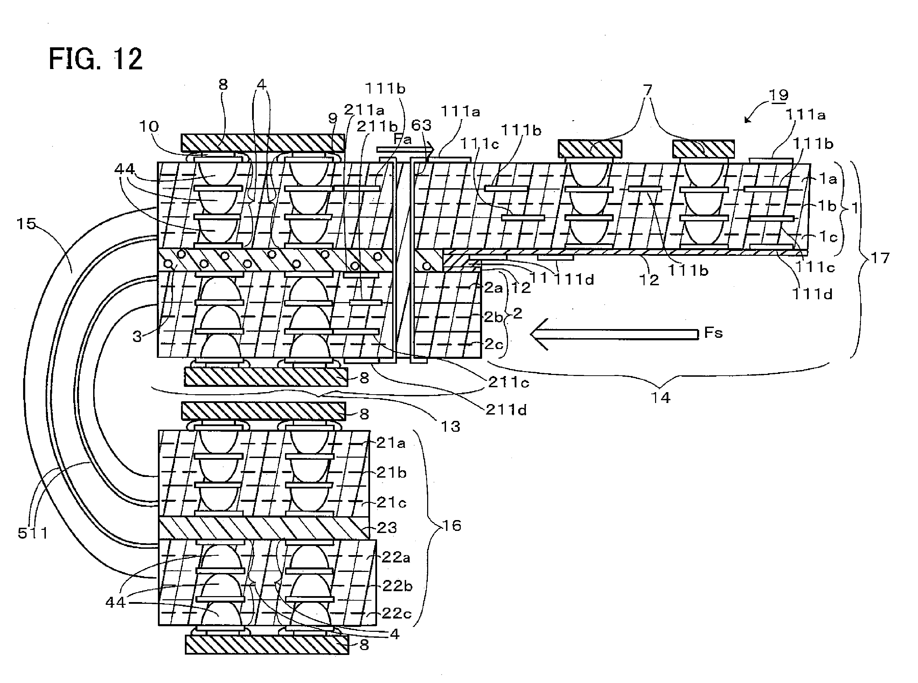

In the above-described First Embodiment, base substrate 3 was made of glass-epoxy resin. And first substrate 1 and second substrate 2 were made of epoxy resin. However, the combination of material for base substrate 3 and material for first substrate 1 and second substrate 2 is not limited to the above. As shown in Fig. 12, according to the Fifth Embodiment, base substrate 3 is formed with resin containing inorganic filler; and first substrate 1 and second substrate 2 are formed with base material of resin-impregnated inorganic fabric. By structuring so, since at least either first substrate 1 or second substrate 2 is reinforced with inorganic fabric, tolerance to warping may be improved. Accordingly, when an electronic device such as a cell phone receives an impact from being dropped or the like, the risk of rupture in the wiring that connects electronic components mounted in the wiring board may be minimized. The above-described inorganic material such as inorganic fabric or inorganic filler has a small coefficient of thermal expansion and small elasticity compared with resin made of organic material. Therefore, when inorganic material such as inorganic fabric or inorganic filler is combined, alignment gaps between connecting lands may be reduced.

In the method of manufacturing a wiring board according to the Fifth Embodiment, referring to Fig. 7D, as the material to form core 55, resin containing inorganic filler is used. In addition, for the resin to be laminated in reference to Figs. 7G, 7J and 7M, a base material of resin-impregnated inorganic fabric is used. The rest is the same as the method of manufacturing a wiring board according to the First Embodiment.

### (OTHER EXAMPLES OF THE PRESENT INVENTION)

According to the above-described embodiments, pliable member 15 connects base substrate 3, a portion of first substrate 1, a portion of second substrate 2, base member 23, a portion of third substrate 21 and a portion of fourth substrate 22. However, the manner in which pliable member 15 connects first wiring board 17 and second wiring board 16 is not limited to such an embodiment.

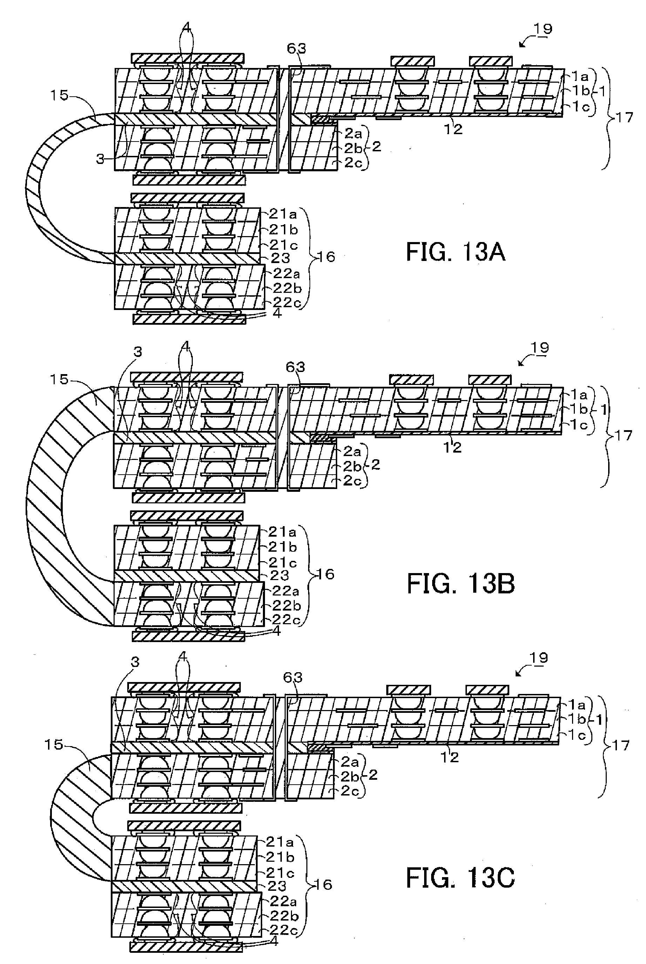

As shown in Fig. 13A, pliable member 15 may also connect first wiring board 17 and second wiring board 16 by connecting base substrate 3 and base member 23. Furthermore, by forming base substrate 3 or base member 23 with pliable material and by extending base substrate 3 or base member 23, either base substrate 3 or base member 23 may serve as pliable member 15 and connect first wiring board 17 and second wiring board 16.

Also, as shown in Fig. 13B, pliable member 15, by connecting first substrate 1 and fourth substrate 22, may also connect first wiring board 17 and second wiring board 16.

Also, as shown in Fig. 13C, pliable member 15, by connecting second substrate 2 and third substrate 21, may also connect first wiring board 17 and second wiring board 16.

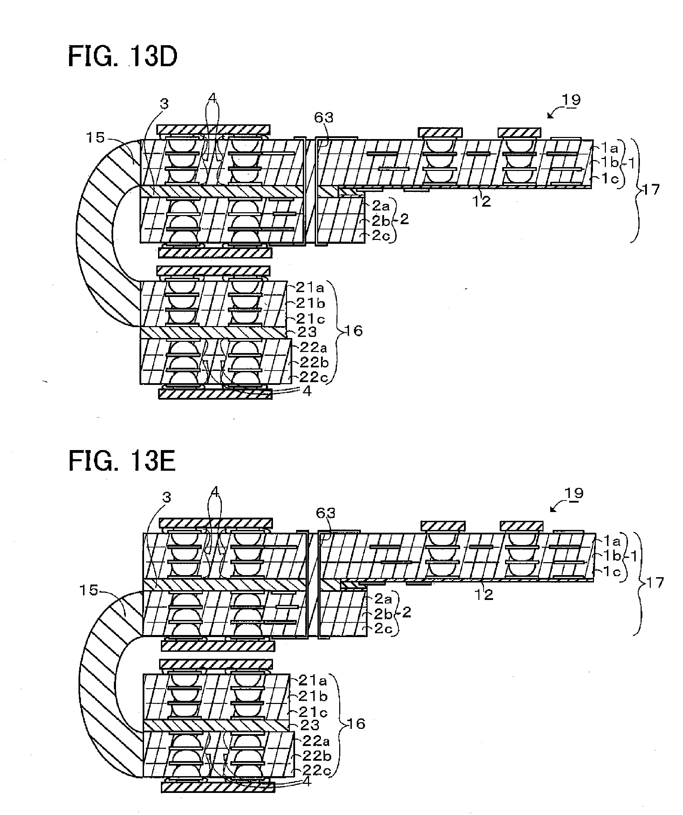

Also, as shown in Fig. 13D, pliable member 15, by connecting first substrate 1 and third substrate 21, may also connect first wiring board 17 and second wiring board 16.

Also, as shown in Fig. 13E, pliable member 15, by connecting second substrate 2 and fourth substrate 22, may also connect first wiring board 17 and second wiring board 16.

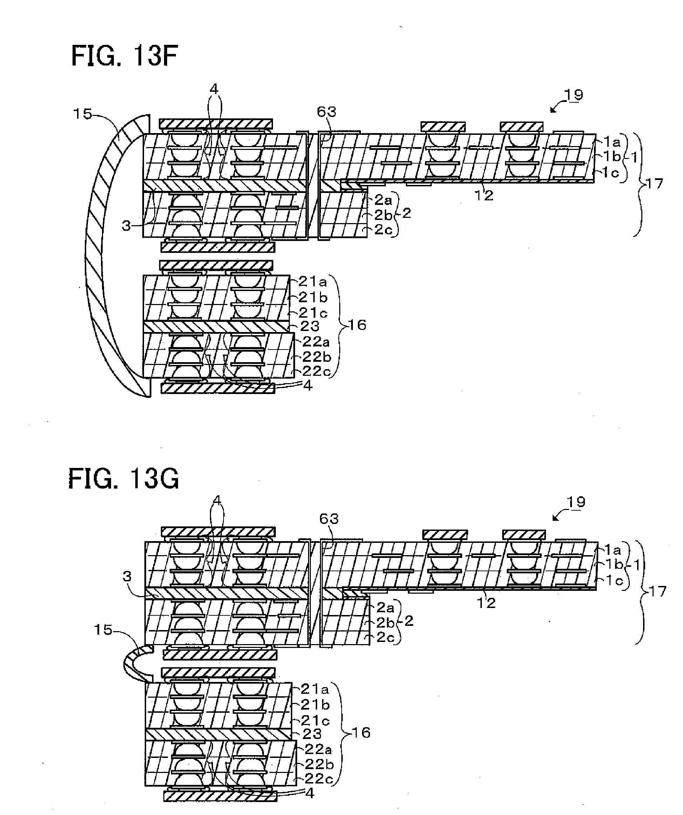

Also, as shown in Fig. 13F, pliable member 15, by connecting the mounting surface of first substrate 1 and the mounting surface of fourth substrate 22, may also connect first wiring board 17 and second wiring board 16.

Also, as shown in Fig. 13G, pliable member 15, by connecting the mounting surface of second substrate 2 and the mounting surface of third substrate 21, may also connect first wiring board 17 and second wiring board 16.

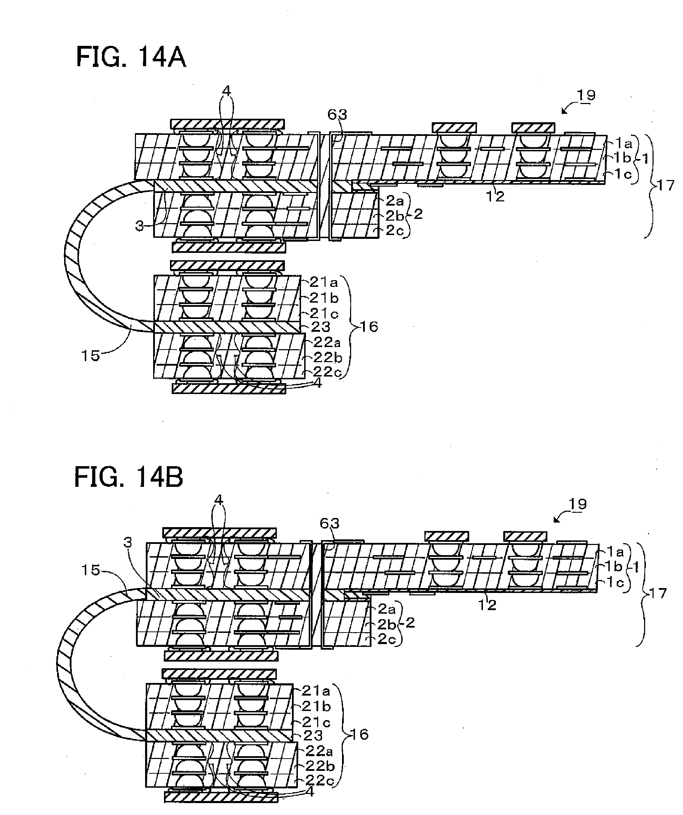

Next, according to the above-described embodiments, one end of first substrate 1 and one end of second substrate 2 are aligned. However, the present invention is not limited to such an embodiment. As shown in Fig. 14A, one end of first substrate 1 may protrude beyond one end of second substrate 2. Here, the thickness of first substrate 1 is made less than that of the central portion. Likewise, the thickness of second substrate 2 is made less than that of the central portion, and the thickness of base substrate 3 is made less than that of the central portion.

Also, as shown in Fig. 14B, one end of second substrate 2 may protrude beyond one end of first substrate 1. Here, the thickness of second substrate 2 is made less than that of the central portion. Likewise, the thickness of first substrate 1 is made less than that of the central portion, and the thickness of base substrate 3 is made less than that of the central portion.

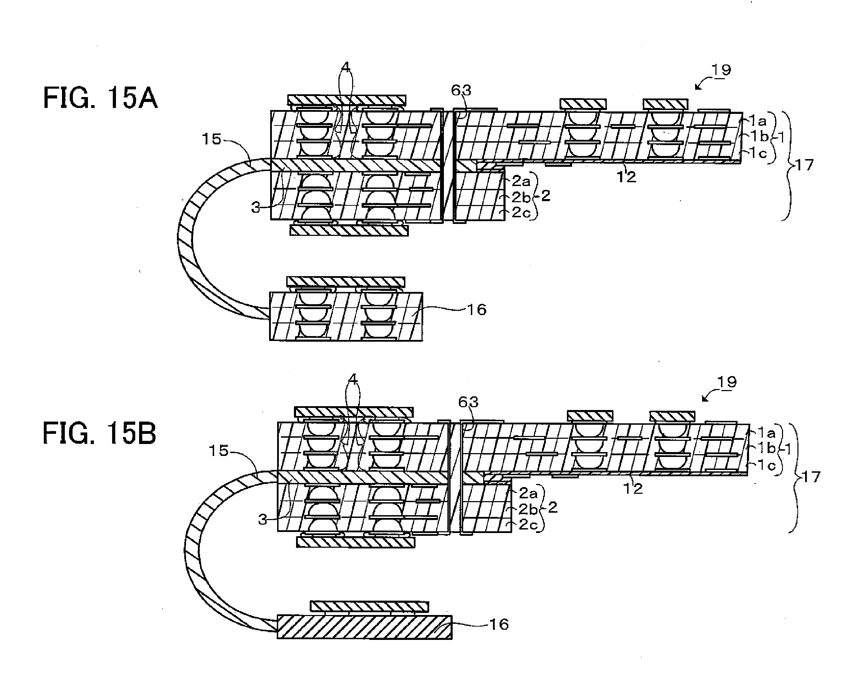

Moreover, according to the above-described embodiments, second wiring board 16 is formed by laminating third substrate 21, base member 23 and fourth substrate 22. However, such is not the only embodiment. Second wiring board 16, for example, as shown in Fig. 15A, may be formed by laminating multiple insulation layers instead of using base member 23. Further, as shown in Fig. 15B, second wiring board 16 may be structured with a single resin layer.

In a wiring board according to the First Embodiment of the present invention, first substrate 1 and second substrate 2 are in a layered structure having a rectangular outline. However, they are not limited to such, but may be in a layered structure having a circular, hexagonal or octagonal outline.

Also, according to the First Embodiment, first substrate 1, second substrate 2, third substrate 21 and fourth substrate 22 are formed with epoxy resin. However, they are not limited to such; first substrate 1, third substrate 21 and fourth substrate 22 may be made of various materials such as polyimide, polycarbonate, polybutylene-telephtarate or polyacrylate. Also, second substrate 2 is not limited to epoxy resin, but various materials may be used as long as they are non-pliable. In addition, if first substrate 1, second substrate 2, third substrate 21 and fourth substrate 22 are made of epoxy resin, naphthalene-type epoxy resin, dicyclo-penta-diene-type epoxy resin, biphenyle-type epoxy resin or bisphenole-type epoxy resin may be used.

In the First Embodiment, as for solder 9, Sn/Ag/Cu was used. However, solder 9 is not limited to such; solder containing antimony, tin, lead, indium or copper may be used. Also, eutectic crystal metals such as Sn/Sb, Sn/Ag, Sn/Pb or Sb/Cu may be used as well. Among such eutectic crystal metals, to avoid having a bad influence on the substrates, using metals having relatively low melting temperatures, 250°C or lower, is preferred.

According to the First Embodiment, interlayer groove section 11 is filled with silicone gel which is viscous silicone. However, filling interlayer groove section 11 is not limited to such, but solid material may be used. As for solid material to be filled in interlayer groove section 11, high-polymer rubber is preferred as a solid material having viscosity and elasticity. More specifically, butyl rubber, isoprene rubber, butadiene rubber, styrene-butadiene rubber or ethylene-propylene rubber may be used. Moreover, interlayer groove section 11 may be filled with a gas. As for the gas to be filled in interlayer groove section 11, a rare gas such as argon, or nitrogen or air may also be used.

According to the Second Embodiment, in opening 5, silicone gel which is viscous silicone is filled. However, the material to be filled in opening 5 is not limited to such, but solid material may be used. As for solid material to be filled in opening 5, high-polymer rubber as a solid material having viscosity and elasticity is preferred. More specifically, butyl rubber, isoprene rubber, butadiene rubber, styrene-butadiene rubber or ethylene-propylene rubber may be used. As for the material to be filled in opening 5, a liquid or solid material is preferred, but a gas may be used. In such a case, as the gas to be filled in opening 5, a rare gas such as argon, or nitrogen or air may be used.

In addition, first substrate 1 is not necessarily formed single-layered, but may be formed multi-layered. Namely, first substrate 1 may be structured with a lower-layer insulation layer and an upper-layer insulation layer. Here, a lower-layer insulation layer indicates the insulation layer formed close to base substrate 3; and an upper-layer insulation layer indicates an insulation layer formed on the outer surface of the wiring board. Furthermore, first substrate 1 may be structured with a lower-layer insulation layer, an upper-layer insulation layer and an intermediate insulation layer placed in between. The intermediate insulation layer may be made multi-layered. In the First Embodiment, the lower-layer insulation layer corresponds to epoxy-resin layer (1c), the intermediate insulation layer corresponds to epoxy-resin layer (1b) and the upper-layer insulation layer corresponds to epoxy-resin layer (1a).

Also, the second substrate is not necessarily formed single-layered, but may be formed multi-layered. Second substrate 2 may also be structured with a lower-layer insulation layer and an upper-layer insulation layer. Furthermore, second substrate 2 may be structured with a lower-layer insulation layer, an upper-layer insulation layer and an intermediate insulation layer placed in between. In the First Embodiment, the lower-layer insulation layer corresponds to epoxy-resin layer (2a), the intermediate insulation layer corresponds to epoxy-resin layer (2b) and the upper-layer insulation layer corresponds to epoxy-resin layer (2c). On top of the upper-layer insulation layer and lower-layer insulation layer, conductive patterns are formed. And, those conductive patterns may be connected with each other through vias 44.

### Industrial Applicability

The present invention may be employed in a wiring board which can mount electronic components, specifically, in a wiring board which can mount electronic components for compact electronic devices.

## Claims

1. A wiring board (19) comprising:
a first wiring board (17), wherein a first substrate (1), a non-pliable second substrate (2) having a smaller mounting area than that of the first substrate (1), and a base substrate (3) formed between the first substrate (1) and the second substrate (2) are laminated, at least a portion of the periphery is made thinner than the central portion, and vias (44) are formed at least either in the first substrate (1) or the second substrate (2);
a second wiring board (16); and
a pliable member (15) connecting the first wiring board (17) and the second wiring board (16).

2. The wiring board (19) according to Claim 1, further comprising a through-hole (63) that penetrates the base substrate (3).

3. The wiring board (19) according to Claim 1, wherein an interlayer groove section (11) is formed between the first substrate (1) and the second substrate (2), and in the interlayer groove section (11), at least either gas, liquid or solid material is filled.

4. The wiring board (19) according to Claim 1, wherein a warping prevention portion (111d) is formed at a step portion created when the first substrate (1) and the second substrate (2) are laminated.

5. The wiring board (19) according to Claim 1, wherein an opening (5) is made at the step portion created when the first substrate (1) and the second substrate (2) are laminated, and in the opening (5), at least either gas, liquid or solid material is filled.

6. The wiring board (19) according to Claim 1, wherein the base substrate (3) is formed with base material of resin-impregnated inorganic fabric, the first substrate (1) is formed with at least either resin containing inorganic filler or pliable resin and the second substrate 2 is formed with at least either resin containing inorganic filler or non-pliable resin.

7. The wiring board (19) according to Claim 1, wherein the base substrate (3) is formed with resin containing inorganic filler, and at least either the first substrate (1) or the second substrate (2) is formed with base material of resin-impregnated inorganic fabric.

8. The wiring board (19) according to Claim 6, wherein the inorganic fabric contains glass cloth.

9. The wiring board (19) according to Claim 6, wherein the inorganic filler contains at least either silica filler or glass filler.

10. The wiring board (19) according to Claim 7, wherein the inorganic fabric contains glass cloth.

11. The wiring board (19) according to Claim 7, wherein the inorganic filler contains at least either silica filler or glass filler.

12. The wiring board (19) according to Claim 2, wherein on the first substrate (1), a conductive pattern is formed; on the second substrate (2), a conductive pattern is formed; and the conductive pattern on the first substrate (1) and the conductive pattern on the second substrate (2) are connected via a through-hole (63).

13. The wiring board (19) according to Claim 1, wherein on the inner surface of the via (44), a conductive layer is formed by plating, and the via (44) is filled with metal.

14. The wiring board (19) according to Claim 1, wherein on the inner surface of the via (44), a conductive layer is formed by plating, and the via (44) is filled with resin.

15. The wiring board (19) according to Claim 1, wherein the first substrate (1) is structured with a lower-layer insulation layer and an upper-layer insulation layer, and the second substrate (2) is structured with a lower-layer insulation layer and an upper-layer insulation layer.

16. The wiring board (19) according to Claim 15, wherein on the upper-layer insulation layer, a conductive pattern is formed; on the lower-layer insulation layer, a conductive pattern is formed; and the conductive pattern on the upper-layer insulation layer and the conductive pattern on the lower-layer insulation layer are connected through vias (44).

17. The wiring board (19) according to Claim 1, wherein on the surface of the pliable member (15), a conductive pattern is formed.

18. A method of manufacturing a wiring board comprising:
a base-substrate forming step to form a base substrate (3);
a connection step to place the pliable member (15) adjacent to the base substrate (3) and also to connect the pliable member (15) to the second wiring board (16);
an insulation-layer forming step to form insulation layers on both surfaces of the base substrate (3), at least one of which is a non-pliable insulation layer;
a via forming step to form vias (44) in the insulation layers; and
a first wiring board (17) forming step, by cutting the insulation layers, to form a first substrate (1) and a non-pliable second substrate (2) having a smaller mounting area than that of the first substrate (1), while forming at least a portion of the periphery to be thinner than the central portion.

19. The method of manufacturing a wiring board according to Claim 18, further comprising a through-hole forming step to form a through-hole (63) which penetrates the base substrate (3).

20. The method of manufacturing a wiring board according to Claim 18, further comprising an interlayer groove section forming step to form an interlayer groove section (11) between the first substrate (1) and second substrate (2); and a filling step to fill at least either gas, liquid or solid material in the interlayer groove section (11).

21. The method of manufacturing a wiring board according to Claim 18, further comprising a warping prevention portion forming step to form a warping prevention portion (111d) at the step portion created when the first substrate (1) and the second substrate (2) are laminated.

22. The method of manufacturing a wiring board according to Claim 18, further comprising an opening forming step to form an opening (5) at the step portion created when the first substrate (1) and the second substrate (2) are laminated, and a filling step to fill at least either gas, liquid or solid material in the opening (5).

23. The method of manufacturing a wiring board according to Claim 18, wherein the base substrate (3) is formed with base material of resin-impregnated inorganic fabric, the first substrate (1) is formed with at least either resin containing inorganic filler or pliable resin, and the second substrate (2) is formed with at least either resin containing inorganic filler or non-pliable resin.

24. The method of manufacturing a wiring board according to Claim 23, wherein the inorganic fabric contains glass cloth.

25. The method of manufacturing a wiring board according to Claim 23, wherein the inorganic filler contains at least either silica filler or glass filler.

26. The method of manufacturing a wiring board according to Claim 18, wherein the base substrate (3) is formed with resin containing inorganic filler, and at least either the first substrate (1) or the second substrate (2) is formed with base material of resin-impregnated inorganic fabric.

27. The method of manufacturing a wiring board according to Claim 26, wherein the inorganic fabric contains glass cloth.

28. The method of manufacturing a wiring board according to Claim 26, wherein the inorganic filler contains at least either silica filler or glass filler.

29. The method of manufacturing a wiring board according to Claim 19, wherein on the first substrate (1), a conductive pattern is formed; on the second substrate (2), a conductive pattern is formed; and the conductive pattern on the first substrate (1) and the conductive pattern on the second substrate (2) are connected via a through-hole (63).

30. The method of manufacturing a wiring board according to Claim 18, wherein on the inner surface of the via (44), a conductive layer is formed by plating, and the via (44) is filled with metal.

31. The method of manufacturing a wiring board according to Claim 18, wherein on the inner surface of the via (44), a conductive layer is formed by plating, and the via (44) is filled with resin.

32. The method of manufacturing a wiring board according to Claim 18, wherein the first substrate (1) is structured with a lower-layer insulation layer and an upper-layer insulation layer, and the second substrate (2) is structured with a lower-layer insulation layer and an upper-layer insulation layer.

33. The method of manufacturing a wiring board according to Claim 32, wherein on the upper-layer insulation layer, a conductive pattern is formed; on the lower-layer insulation layer, a conductive pattern is formed; and the conductive pattern on the upper-layer insulation layer and the conductive pattern on the lower-layer insulation layer are connected through vias (44).

34. The method of manufacturing a wiring board according to Claim 18, wherein on the surface of the pliable member (15), a conductive pattern is formed.
